# EUROPEAN PATENT APPLICATION

(11) **EP 4 808 313 A1**
(43) Date of publication of application: **16.09.2026**
(21) Application number: 26158043.5
(22) Date of filing: 12.02.2026
(51) Int. Cl.: H10F 39/18, H10F 39/00, H10F 77/40

(54) **SHORT-WAVE INFRARED PIXELS BASED ON NON-SCATTERING NANOSTRUCTURES**

(30) Priority: 13.03.2025 US 202563771613 P; 14.06.2025 US 202519238437
(71) Applicant: Samsung Electronics Co., Ltd., Suwon-si, Gyeonggi-do 16677 (KR)
(72) Inventor: SIDDIQUE, Radwanul Hasan, San Jose, CA, 95134 (US)
(74) Representative: Kuhnen & Wacker Patent- und Rechtsanwaltsbüro PartG mbB

(57) **Abstract**

Provided are systems, methods, and apparatuses for short-wave infrared pixels based on non-scattering nanostructures. In one or more examples, a pixel of a of an image sensor comprises a back reflector (205) formed on a substrate, the back reflector being configured to reflect electromagnetic radiation; a first doped region of a first semiconductor formed adjacent to the back reflector (205); an absorption region of a second semiconductor configured as a photodetector (210) of the pixel, the absorption region being formed adjacent to at least a portion of the first doped region; a second doped region of the first semiconductor formed adjacent to the absorption region, the second doped region being configured to pass the electromagnetic radiation to the absorption region; and a nanostructure (230) formed adjacent to the second doped region, the nanostructure (230) being configured to: steer light that passes through the nanostructure (230) towards the absorption region; and steer, towards the absorption region, a portion of the light that reflects off the back reflector (205).

## Description

### TECHNICAL FIELD

The disclosure relates generally to image sensors, and more particularly to short-wave infrared pixels based on non-scattering nanostructures.

### SUMMARY

The systems and methods described herein may include and/or may be based on microlenses. A microlens can be a relatively small lens that is usually less than a millimeter in diameter. Some microlenses may be made of a variety of plastic materials, polymers, etc. Polymer microlens arrays (MLAs) are used in a variety of applications, including optical sensors, 3D displays, lighting devices, 4D light-fields, etc. MLAs can increase the light collection efficiency of imaging systems. These arrays can collect and focus light onto the photosensitive areas of a given imaging system.

The systems and methods described herein may include and/or may be based on nanostructures. A metasurface or nanostructure can include a two-dimensional planar structure that includes sub-wavelength sized elements designed to control the propagation and scattering of electromagnetic waves by manipulating their phase, amplitude, and polarization, acting like a customized optical surface with unique properties. Microlenses or metalenses can use nanostructures or metasurfaces to manipulate light by locally controlling wavefronts. Non-scattering nanostructures are designed to suppress or eliminate light scattering, achieved by carefully engineering the structure to minimize electromagnetic energy leakage. Instead of reflecting or refracting light, non-scattering nanostructures can guide or confine light within the material or absorb it, reducing the scattering of light. Dielectric materials, such as silicon-based structures, can be used to create non-scattering nanostructures.

The systems and methods described herein may include and/or may be based on shortwave infrared (SWIR). SWIR can refer to a region of the electromagnetic spectrum that is invisible to the human eye, roughly 0.9 and 1.7 micrometers, or 900 to 1700 nanometers (nm). SWIR can be detected by some imaging systems, enabling applications in various fields. For example, SWIR sensitive silicon (Si) photodetectors (PDs) may be used for active 3D imaging (e.g., time of flight, single photon avalanche diode (SPAD), structured light, augmented reality), machine vision applications (e.g., internet of things, security, robotics), healthcare (photoplethysmography, multispectral), automotive (advanced driver assistance systems, in-cabin sensors), optical interconnects for communication and data centers, quantum communications and quantum key distribution, and the like.

Some imaging systems can be based on or implement quantum dots, organic photodiodes, germanium-based technologies, among other technologies aimed at efficient and low-cost operation. One of the limitations of SWIR CIS is that these photodiodes are not CMOS or Si compatible and relatively expensive.

Quantum efficiency (QE) can indicate the effectiveness of an imaging device in converting incident photons into electrons (e.g., fraction of incident photons that a device successfully converts into a signal). Some imaging systems, such as germanium-on-silicon (Ge-on-Si), can have a relatively low QE for target wavelength of sensing or optical interconnects (e.g., less than 50% QE). Some imaging systems, such as Ge-on-Si, can have relatively low intrinsic SWIR sensitivity (e.g., between 1330-1600 nm).

Photon detection efficiency (PDE) can indicate a probability that a silicon photomultiplier (SiPM) produces an output signal in response to an incident photon. It can be based on a function of overvoltage ΔV and wavelength λ of the incident light.

In various embodiments, the systems and methods described herein include systems, methods, and apparatuses for short-wave infrared pixels based on non-scattering nanostructures. In some aspects, the techniques described herein relate to a pixel of an image sensor including: a back reflector formed on a substrate, the back reflector being configured to reflect electromagnetic radiation; a first doped region of a first semiconductor formed adjacent to the back reflector; an absorption region of a second semiconductor configured as a photodetector of the pixel, the absorption region being formed adjacent to at least a portion of the first doped region; a second doped region of the first semiconductor formed adjacent to the absorption region, the second doped region being configured to pass the electromagnetic radiation to the absorption region; and a nanostructure formed adjacent to the second doped region, the nanostructure being configured to: steer light that passes through the nanostructure towards the absorption region; and steer, towards the absorption region, a portion of the light that reflects off the back reflector.

In some aspects, the techniques described herein relate to a pixel of an image sensor, wherein: the nanostructure comprises segments of a first material interleaved with segments of a second material, the first material has a first refractive index, and the second material has a second refractive index different from the first refractive index.

In some aspects, the techniques described herein relate to a pixel of an image sensor, wherein the second material comprises at least a portion of the second doped region.

In some aspects, the techniques described herein relate to a pixel of an image sensor, wherein: the pixel comprises a metal contact, the metal contact connecting the pixel to a transistor, and the back reflector comprises at least one of one or more metal layers, one or more dielectric layers, one or more vias of the pixel, or at least a portion of the metal contact.

In some aspects, the techniques described herein relate to a pixel of an image sensor, wherein: at least a portion of the absorption region comprises an undoped semiconductor, the first doped region comprises a first doping, and the second doped region comprises a second doping, the second doping having an opposite polarity of the first doping.

In some aspects, the techniques described herein relate to a pixel of an image sensor, wherein: the first semiconductor comprises at least one of silicon, germanium, or indium phosphide, and the second semiconductor comprises at least one of germanium or indium gallium arsenide.

In some aspects, the techniques described herein relate to a pixel of an image sensor, wherein at least one of the first semiconductor or the second semiconductor comprise at least one of gallium arsenide, cadmium telluride, mercury cadmium telluride, lead sulfide, indium arsenide, vanadium oxide, phosphorene, or graphene.

In some aspects, the techniques described herein relate to a pixel of an image sensor, wherein a height of an element of the nanostructure: is greater than or equal to a lowest wavelength of a target electromagnetic radiation spectra, and is inversely proportional to an effective refractive index of a material of the nanostructure.

In some aspects, the techniques described herein relate to a pixel of an image sensor, wherein a spacing between a first element and a second element of the nanostructure is less than or equal to half of the lowest wavelength of the target electromagnetic radiation spectra.

In some aspects, the techniques described herein relate to a pixel of an image sensor, wherein the nanostructure comprises at least one of an element spacing, an element width, an element height, or an element type, the element type including at least one of a pillar, a hole, or a grating.

In some aspects, the techniques described herein relate to a pixel of an image sensor, further including: a microlens formed adjacent to the nanostructure, the microlens including one or more lenses that include at least one of a flat coat layer or a curved lensing layer, wherein the nanostructure comprises a passivation layer formed adjacent to the microlens, the passivation layer including at least one thin film dielectric.

In some aspects, the techniques described herein relate to a pixel of an image sensor, wherein: the nanostructure is configured for a first chief ray angle (CRA) based on a first lens of the pixel, and a second pixel is associated with a second nanostructure configured for a second CRA based on a second lens of the second pixel, the second CRA being different from the first CRA.

In some aspects, the techniques described herein relate to a method, the method including: forming a back reflector on a substrate of a pixel, the back reflector being configured to reflect electromagnetic radiation; forming a first doped region of a first semiconductor adjacent to the back reflector; forming an absorption region of a second semiconductor adjacent to at least a portion of the first doped region, the absorption region being configured as a photodetector; forming a second doped region of the first semiconductor adjacent to the absorption region, the second doped region being configured to pass the electromagnetic radiation to the absorption region; and forming a nanostructure adjacent to the second doped region, the nanostructure configured to allow light incident on the pixel to pass through the nanostructure and to steer a portion of the light reflected off the back reflector towards the absorption region.

In some aspects, the techniques described herein relate to a method, wherein: the nanostructure comprises segments of a first material interleaved with segments of a second material, the first material has a first refractive index, and the second material has a second refractive index different from the first refractive index.

In some aspects, the techniques described herein relate to a method, wherein the second material comprises at least a portion of the second doped region.

In some aspects, the techniques described herein relate to a method, wherein: the pixel comprises a metal contact, the metal contact connecting the pixel to a transistor, and the back reflector comprises at least one of one or more metal layers, one or more dielectric layers, one or more vias of the pixel, or at least a portion of the metal contact.

In some aspects, the techniques described herein relate to a method, wherein: at least a portion of the absorption region comprises an undoped semiconductor, the first doped region comprises a first doping, and the second doped region comprises a second doping, the second doping having an opposite polarity of the first doping.

In some aspects, the techniques described herein relate to an image sensor system, the image sensor system including: a pixel array, wherein a pixel of the pixel array comprises: a back reflector formed on a substrate, the back reflector being configured to reflect electromagnetic radiation; a first doped region of a first semiconductor formed adjacent to the back reflector; an absorption region of a second semiconductor configured as a photodetector of the pixel, the absorption region being formed adjacent to at least a portion of the first doped region; a second doped region of the first semiconductor formed adjacent to the absorption region, the second doped region being configured to pass the electromagnetic radiation to the absorption region; and a nanostructure formed adjacent to the second doped region, the nanostructure being configured to: steer light that passes through the nanostructure towards the absorption region; and steer, towards the absorption region, a portion of the light that reflects off the back reflector.

In some aspects, the techniques described herein relate to an image sensor system, wherein: the nanostructure comprises segments of a first material interleaved with segments of a second material, the first material has a first refractive index, and the second material has a second refractive index different from the first refractive index.

In some aspects, the techniques described herein relate to an image sensor system, wherein the second material comprises at least a portion of the second doped region.

In various embodiments, the systems, methods, and apparatuses described herein provide improved short-wave infrared pixels based on non-scattering nanostructures. The systems and methods described herein provide non-scattering nanostructures and a back reflector to SWIR based photodetectors. The systems and methods described herein provide multiple benefits and advantages. For example, adding non-scattering nanostructures and a back reflector to SWIR based photodetectors can improve light absorption, resulting in an increase in QE and PDE in SWIR photodetectors. In some cases, the non-scattering nanotechnology systems and methods described herein can provide up to two-times greater QE while reducing crosstalk and parasitic light sensitivity (PLS) up to three times compared to some systems, such as backside scattering technology (BST). A simulated light field map shows that, while BST scatters light everywhere in a given photodiode (PD) and surrounding diodes (SD) or transistors, the non-scattering nanotechnology systems and methods described herein trap incident light within the PD without the light escaping out of the lens or scattering to the storage nodes. Thus, the non-scattering nanotechnology systems and methods described herein can improve the bandwidth of the PD for optical interconnect applications. With such improved sensitivity, the non-scattering nanotechnology systems and methods described herein can increase the performance of SWIR sensors. For example, the non-scattering nanotechnology described herein can double the range resolution and extension for time of flight (ToF) sensors while reducing PLS (e.g., up to 3X reduction). Also, the non-scattering nanotechnology described herein can increase jitter and PDE performance (e.g., up to 2X improvement over some systems). For global shutter, the non-scattering nanotechnology described herein can increase SNR and high dynamic range (HDR) performance (e.g., over 2X increase compared to some systems). Systems based on the non-scattering nanotechnology described herein can achieve these advantages with lower transmit power, making the non-scattering nanotechnology systems and methods described herein suitable for low-light applications.

### BRIEF DESCRIPTION OF THE DRAWINGS

The above-mentioned aspects and other aspects of the present systems and methods will be better understood when the present application is read in view of the following figures in which like numbers indicate similar or identical elements. Further, the drawings provided herein are for purpose of illustrating certain embodiments only; other embodiments, which may not be explicitly illustrated, are not excluded from the scope of this disclosure.

These and other features and advantages of the present disclosure will be appreciated and understood with reference to the specification, claims, and appended drawings, wherein:
FIG. 1 illustrates an example system in accordance with one or more implementations as described herein.
FIG. 2 illustrates details of the system of FIG. 1, according to one or more implementations as described herein.
FIGs. 3A-3D illustrates example lens configurations in accordance with one or more implementations as described herein.
FIG. 4 illustrates an example of nanostructure in accordance with one or more implementations as described herein.
FIG. 5 illustrates an example architecture in accordance with one or more implementations as described herein.
FIG. 6 illustrates an example architecture in accordance with one or more implementations as described herein.
FIG. 7 illustrates an example architecture in accordance with one or more implementations as described herein.
FIG. 8 illustrates an example architecture in accordance with one or more implementations as described herein.
FIG. 9 illustrates an example architecture in accordance with one or more implementations as described herein.
FIG. 10 illustrates an example nanostructure in accordance with one or more implementations as described herein.
FIG. 11 depicts a flow diagram illustrating an example method associated with the disclosed systems, in accordance with example implementations described herein.
FIG. 12 depicts a flow diagram illustrating an example method associated with the disclosed systems, in accordance with example implementations described herein.
FIG. 13 illustrates an example system in accordance with one or more implementations as described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the spirit and scope of the present systems and methods as defined by the appended claims.

### DETAILED DESCRIPTION OF VARIOUS EMBODIMENTS

The details of one or more embodiments of the subject matter described herein are set forth in the accompanying drawings and the description below. Other features, aspects, and advantages of the subject matter will become apparent from the description, the drawings, and the claims.

Various embodiments of the present disclosure now will be described more fully hereinafter with reference to the accompanying drawings, in which some, but not all embodiments are shown. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media include all computer-readable media (including volatile and non-volatile media).

Embodiments of the present disclosure are described below with reference to block diagrams and flowchart illustrations. Thus, it should be understood that each block of the block diagrams and flowchart illustrations may be implemented in the form of a computer program product, an entirely hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some example embodiments, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The following description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

Furthermore, any element in a claim that does not explicitly state "means for" performing a specified function, or "step for" performing a specific function, is not to be interpreted as a "means" or "step" clause.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Any data processing may include data buffering, aligning incoming data from multiple communication lanes, forward error correction ("FEC"), and/or others. For example, data may be first received by an analog front end (AFE), which prepares the incoming for digital processing. The digital portion (e.g., DSPs) of the transceivers may provide skew management, equalization, reflection cancellation, and/or other functions. It is to be appreciated that the process described herein can provide many benefits, including saving both power and cost.

Moreover, the terms "system," "component," "module," "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, system-on-a-chip, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

Some aspects of the systems and methods described herein may be configured to detect electromagnetic radiation. The detected electromagnetic radiation may include at least a partial range of infrared light, near-infrared light, visible light, ultraviolet light, etc. A near-infrared (NIR) sensitive silicon (Si) photodetector (PD) may be used for active 3D imaging (time of flight (ToF), structured light, augmented reality (AR)), machine vision applications (internet of things (IoT), security, robotics) and automotive applications (advanced driver-assistance system (ADAS), in-cabin sensors). A microlens may direct incident light towards the photodetector. The photodetector (e.g., photodiode) may be configured to convert photon energy into an electrical signal.

A microlens can be a relatively small lens that is usually less than a millimeter in diameter. Some microlenses may be made of a variety of organic materials, plastic materials, polymers, etc. Polymer microlens arrays (MLAs) may be used in a variety of applications, including optical sensors, 3D displays, lighting devices, 4D light-fields, etc. MLAs can increase the light collection efficiency of image sensors. MLA arrays can collect and focus light onto the photosensitive areas of the image sensor.

The systems and methods described herein may include nanostructures. In some examples, the systems and methods may include a microlens configured to focus light towards a nanostructure. Nanostructures (e.g., nanostructured patterns) may include nanoscale structures created on the surface of a substrate. Nanopatterning can be the process of creating these patterns, which may have at least one dimension that may be smaller than 100 nanometers (nm). Nanostructures may include materials with at least one dimension in the nanoscale range (<100 nm). In some cases, nanostructures of the systems and methods described herein may include at least one dimension in the range of 50 to 400 nm. Nanostructures can be made of a single material or multiple materials. Nanostructures can have different shapes, including square, round, oval, spherical, triangular, pyramidical (e.g., 3-sided, 4-sided, etc.), rod, hexagonal, cubic, amorphous, needle-like, crystalline, and/or any given shape. Nanostructures can include multiple layers (e.g., stacked vertically). These layers can be similar and/or different in size, shape, height, placement, structure, etc.

In some cases, at least a portion of the nanostructure may include metamaterials. In some cases, nanostructures may be referred to as metamaterials. Metamaterials are artificial materials that interact with light and other forms of energy in ways that are not found in nature. Metamaterials can be configured into a patterned array not found in nature. These patterns can be of materials at the nanoscale and/or microscale, and may include a repeating pattern, a non-repeating pattern, a periodic pattern, and/or an aperiodic pattern. The shape, geometry, size, orientation, and arrangement of the materials may produce a number of effects, especially on the surface of a thin film, also known as a metasurface. A metamaterial pattern may use elements and patterns having a size that varies within a fraction of a target wavelength. A metamaterial pattern can vary depending on the target wavelength. Metamaterials can be 3D structures made up of at least two different materials. Metamaterials may be designed around unique micro- and nanoscale patterns or structures called "meta-atoms." These structures provide optical properties that can be shaped on length scales below the wavelength of light. Metasurfaces can transmit or reflect light to focus and steer it, as well as perform other types of wave manipulation. Metamaterials can also interact strongly with light, significantly changing the properties of light over a subwavelength thickness. Metamaterials can be used in many applications, including anechoic chambers, scattering control, photodetectors, microbolometers, solar cells, microwave energy harvesting, sensor and radar cross-section reduction applications, etc.

An electromagnetic metasurface may refer to a kind of artificial sheet material with sub-wavelength thickness. Metasurfaces can be either structured or unstructured, with subwavelength-scaled patterns in the horizontal dimensions. In electromagnetic theory, metasurfaces modulate the behaviors of electromagnetic waves through specific boundary conditions rather than constitutive parameters in three-dimensional (3D) space, which is commonly exploited in natural materials and metamaterials. Metasurfaces may also refer to the two-dimensional counterparts of metamaterials. There can be 2.5D metasurfaces that involve the third dimension as an additional degree of freedom for tailoring their functionality.

In some examples, the systems and methods may include one or more thin film semiconductors. A thin film semiconductor is a layer of semiconductor material that is grown or deposited on a substrate. Thin films are typically a few nanometers to microns thick. For example, thin films can range from a few atoms to 100 micrometers thick. A thin film layer that is less than 2 micrometers thick is considered relatively thin, while a thin film layer that is more than 20 micrometers is considered relatively thick. Thin films are made by growing or depositing layers of semiconductor material on a substrate using various deposition processes. Thin film deposition is the process of creating and applying thin film coatings to a substrate material. Deposition processes include vaporization and condensation (e.g., vaporize the solid material and condense it onto the substrate), gas or vapor reaction (e.g., the gas or vapor reacts with the substrate to create a solid thin film), thermal evaporation (e.g., deposit pure metals, non-metals, oxides, and nitrides), magnetron sputtering (e.g., use a physical phenomenon to expel microscopic particles of solid materials from their surface), physical vapor deposition (PVD), chemical vapor deposition (CVD), electron beam (e-beam) evaporation. The coatings can be made of one or more materials, such as metals, oxides, compounds, etc. In thin film deposition, material is added to the substrate in the form of thin film layers. These layers can be structural or act as spacers that can later be removed. Deposition techniques may control layer thickness within a few tens of nanometers. Thin film deposition can be done by processing above the substrate surface, typically a silicon wafer with a thickness of 200-700 µm.

In some examples, the nanostructures of the systems and methods may modify or modulate the phase of incident electromagnetic radiation (e.g., incident light). Phase modulation is a process that changes the phase angle of a carrier wave to match a data signal. This adjustment allows for efficient data transmission over different mediums. Phase modulators may manipulate the phase of electromagnetic radiation (e.g., heat, light). Phase modulation of electromagnetic wavelengths may include focusing, steering, scattering, phase shifting, polarizing, etc. Phase-modulating may reduce aberrations, improve efficiency, alter the polarization of electromagnetic radiation, and/or change the field of view, among other benefits. Such phase-modulating may allow for optimization of a pixel array (e.g., image sensor array) at the sensor level, optimizing the electromagnetic radiation for a specific location or predetermined target wavelength.

A metasurface thin film thus may use nanoscale and microscale elements to alter electromagnetic waves traveling through the thin film. By careful choice of patterns, a metasurface may create, within the thin film layer, local conditions that alter the index of refraction, and thus alter the magnitude of interaction with electromagnetic radiation through the thin film. By doing so, phases of electromagnetic radiation passing through the thin film may be modulated. Due to some of the metasurface elements being subwavelength, the metasurface elements may produce changes at a much smaller size than conventional optics. Additionally, although refractive indexes may be used, changes in refractive indexes may be related to the differences in the dielectric constant. As such, a high-index material may have a higher dielectric constant, while a low-index material may have a lower dielectric constant.

In some cases, the fabrication of a pixel of an image sensor may include at least one of a gate structure, a semiconductor substrate formed over the gate structure, an inter-layer dielectric layer (e.g., a second inter-layer dielectric layer with a first inter-layer dielectric layer part of the gate structure layer) formed over the semiconductor substrate, a passivation layer formed over the inter-layer dielectric, at least one nanostructure layer formed over the passivation layer, an antireflective layer formed over the at least one nanostructure layer, and a microlens formed over the antireflective layer. In some cases, the gate structure may include a back end of line (e.g., with metal interconnect layers) that is patterned on a wafer (e.g., on front end of line layer). In some cases, the gate structure may include an inter-layer dielectric (e.g., a first inter-layer dielectric layer deposited on or adjacent to the back end of line). In some cases, the back reflector may be incorporated in the gate structure (e.g., in the back end of line layer or inter-layer dielectric layer). The photodetector may be formed in or on the semiconductor substrate. In some cases, the second inter-layer dielectric adjacent to the passivation layer may include at least one metal shield (e.g., back-side metal shield).

Fill factor of an image sensor is the ratio of light-sensitive area of a pixel to total pixel area in an image sensor. A higher fill factor means the sensor is more sensitive to light (e.g., more efficient). Fill factor ratios vary by device, but generally range from 30% to 80% of the pixel area. A lower fill factor means the sensor is less sensitive and requires longer exposure times.

In some examples, the nanostructures of the systems and methods described herein may include holes (e.g., hole-based thin film), pillars (e.g., pillar-based thin film), optical gratings, etc. A hole-based thin film is a thin film with an array of nanometer and/or micrometer-sized holes. A hole is a void area with air or a relatively low refractive index medium surrounded by a relatively high refractive index medium. Electromagnetic radiation (e.g., infrared, thermal) may travel unimpeded through such holes. A hole-based nanostructure may use an array of nanometer- and/or micrometer-sized holes to modulate electromagnetic radiation (e.g., focus, steer, scatter, phase shift, polarize infrared wavelengths). A pillar-based thin film is a thin film with nanostructures and/or microstructures made of isolated pillars (e.g., pillars of high refractive index surrounded by a low refractive index medium). Thin films can be layers of material deposited on a bulk substrate to give the substrate additional properties. Thin films can be used in a variety of surface coatings to alter opto-electronic properties or increase wear or corrosion resistance. A pillar-based nanostructure may include a surface with a semiconductor layer. The semiconductor may be etched with an array of pillars that are nanometers to tens of microns high.

The techniques described herein include logic to provide short-wave infrared pixels based on non-scattering nanostructures. The logic includes any combination of hardware (e.g., at least one memory, at least one processor), logical circuitry, firmware, and/or software to fabricate, incorporate, and/or implement short-wave infrared pixels based on non-scattering nanostructures.

Based on the system and methods described, quantum efficiency (QE) is increased (e.g., greater than 50% quantum efficiency with incident light at or relatively near to near-infrared wavelengths). The systems and methods provide a relatively higher QE based on a relatively thinner photodetector (e.g., from 0.01 to 10 micrometers), where the thickness of the photodetector is measured from a top of the photodetector towards the nanostructure to a bottom of the photodetector towards the back reflector (e.g., relatively equivalent to the substrate), the incident light traveling in a linear direction in line with the microlens, the nanostructure, the photodetector, and the back reflector. Based on the systems and methods, crosstalk (e.g., photons incident at a first pixel being detected at an adjacent second pixel) and dark noise are reduced. In some cases, the systems and methods may include a photodetector that is part of or is a sub-section of the substrate. For example, the systems and methods may include a semiconductor substrate and a part of the substrate may be doped to make a photodetector out of the semiconductor substrate.

Some photodetectors (e.g., silicon photodetectors) may be configured with scattering elements (e.g., scattering nanostructures) configured to scatter light to increase photoelectron count at the photodetector. However, scattering elements can cause crosstalk where some of the photons being scattered at a first photodetector travel to other photodetectors adjacent to the first photodetector.

Based on the systems and methods described herein, an image sensor may include a semiconductor substrate that includes multiple pixel regions (e.g., an image sensing pixel array). A pixel may include a first surface (e.g., a substrate layer), and a second surface (e.g., semiconductor layer, nanostructure layer, etc.) opposing the first surface. In some cases, the image sensor may include multiple transistors adjacent to the first surface of the semiconductor substrate in each of the pixel regions (e.g., in each pixel). In some cases, the image sensor may include a metallic back reflector in the first surface. In some examples, the image sensor may include nanostructures on the second surface in the pixel region, where the nanostructures may be configured to linearize a direction (e.g., minimize scattering) of incident light.

Based on the systems and methods described herein, the fabrication of a pixel of an image sensor may include at least one of a gate structure, a semiconductor substrate formed over the gate structure, an inter-layer dielectric layer (e.g., a second inter-layer dielectric layer with a first inter-layer dielectric layer part of the gate structure layer) formed over the semiconductor substrate, a passivation layer formed over the inter-layer dielectric, at least one nanostructure layer formed over the passivation layer, an antireflective layer formed over the at least one nanostructure layer, and a microlens formed over the antireflective layer.

In some cases, the gate structure may include a back end of line (e.g., with metal interconnect layers) that is patterned on a wafer (e.g., on front end of line layer). In some cases, the gate structure may include an inter-layer dielectric (e.g., a first inter-layer dielectric layer deposited on or adjacent to the back end of line). In some cases, the back reflector may be incorporated in or integrated with the gate structure (e.g., in the back end of line layer or inter-layer dielectric layer). The photodetector may be formed in or on the semiconductor substrate. In some cases, the second inter-layer dielectric adjacent to the passivation layer may include at least one metal shield (e.g., back-side metal shield, back reflector).

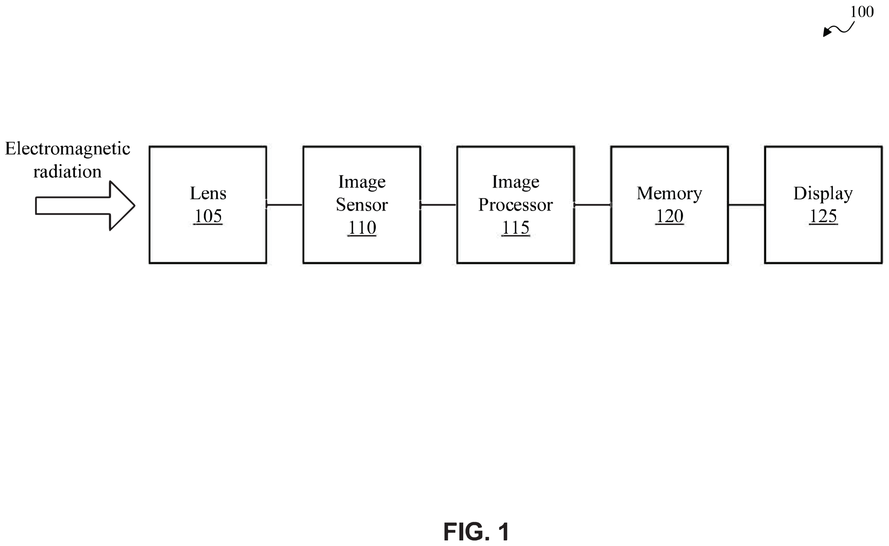

**FIG. 1** illustrates an example imaging system 100 in accordance with one or more implementations as described herein. According to the illustrated example, imaging system 100 may include lens 105, image sensor 110, image processor 115, memory 120, and display 125.

In one or more examples, lens 105 may be configured to focus, deflect, guide, bend, and/or route incident electromagnetic energy (e.g., visible light radiation, infrared radiation, thermal radiation) onto image sensor 110. In some cases, lens 105 may include a filter configured to allow one or more selected spectral bands to pass while blocking other spectral bands. In some cases, lens 105 may include at least one microlens (e.g., microlens array), at least one metalens (e.g., one or more multi-layered metalenses), at least one nanostructure lens (e.g., one or more metamaterial lenses of pillars, holes, and/or gratings in the nanometer scale), at least one curved lens (e.g., of organic materials), at least one flat lens, etc.

In some implementations, image sensor 110 may be configured to detect incident light (e.g., photons) and convert the light to an electrical signal (e.g., photoelectrons). In some cases, image sensor 110 may include a cooling system that chills image sensors (e.g., image sensor 110) to reduce thermally induced noise below the level of the imaging signal at the scene being detected.

In some examples, image processor 115 may be configured to process image data. In some cases, image processor 115 may include a thermal image processor configured to process thermal image data detected by image sensor 110. In some examples, image processor 115 may include an ADC to detect and convert electromagnetic radiation detected by image sensor 110 to a digital signal. In some cases, image sensor 110 may include a DSP to process the digital signal. In some examples, image processor 115, in conjunction with memory 120, may record image data.

In one or more examples, memory 120 may be configured to store data generated by image sensor 110 and/or data processed by image processor 115. In some examples, memory 120 includes DRAM to store image data (e.g., the electrical signal of the IR sensor, the digital signal of the image processor 115, etc.). Additionally, or alternatively, memory 120 includes cache memory (e.g., SRAM) to hold data being processed by image processor 115.

In some cases, display 125 may be configured to display image data detected by image sensor 110 and processed by image processor 115 (e.g., display a field of view of imaging system 100, display a captured image stored in memory 120). In some cases, image processor 115 may perform object detection based on image data detected by image sensor 110. In some examples, display 125 may be configured to show objects detected by image sensor 110 and processed by image processor 115.

The systems and methods described herein include multiple advantages and benefits. For example, the systems and methods provide up to a twofold improvement in QE while reducing crosstalk and up to a three-fold reduction in parasitic light sensitivity. The simulated light field map shows that while scattering nanostructures (BST) scatters light everywhere in the photodiode (PD) and surrounding diodes (SD) or transistors, non-scattering nanostructures (NST) traps the light within PD without scattering to the storage nodes. Based on the improved sensitivity of the systems and methods, the performance of associated sensors is increased. For example, the systems and methods provide up to a multi-fold increase in range resolution and extension for time of flight (ToF) sensors. For single photon avalanche diode (SPAD) sensors, the systems and methods can provide over a two-fold increase in photon detection efficiency (PDE) performance while increasing photon-timing precision (e.g., decreasing timing jitter). In global shutter implementations, the systems and methods can provide over a two-fold increase in SNR and high dynamic range performance. The systems and methods operate with relatively low transmit power, making the systems and methods suitable for low-light applications. The systems and methods can be extended to multiple spectrums (e.g., visible spectrum, infrared spectrum, near-infrared spectrum, etc.). This multi-spectrum applicability makes the systems and methods suitable for automotive applications (e.g., ADAS, in-cabin sensors, etc.). With infrared applications, the systems and methods trap and direct infrared light and/or near-infrared light just as with other spectrums, providing a two-fold improvement in QE in infrared and near-infrared applications. The systems and methods provide the ability to provide a QE above 90% (e.g., for red spectrums).

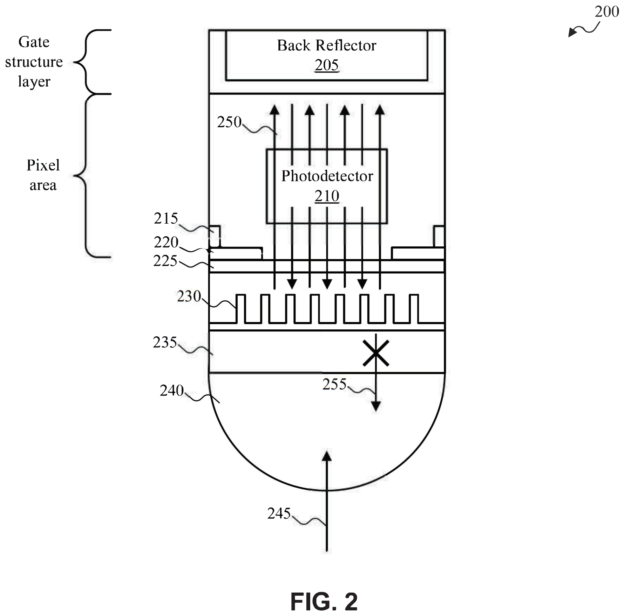

**FIG. 2** illustrates an example pixel 200 in accordance with one or more implementations as described herein. In the illustrated example, pixel 200 may include back reflector 205, photodetector 210, trench insulator 215, inter-layer dielectric layer 220, passivation layer 225, nanostructure 230, anti-reflective layer 235, and lens 240. In some examples, pixel 200 may represent a pixel of image sensor 110 of FIG. 1. Lens 240 may be an example of lens 105 of FIG. 1. Light incident on pixel 200 may be processed by an image processor (e.g., image processor 115 of FIG. 1). As shown, a gate structure layer may include back reflector 205. As shown, a pixel area of pixel 200 may include photodetector 210 (e.g., of a semiconductor layer), trench insulator 215, and/or inter-layer dielectric layer 220. In some cases, nanostructures of pixel 200 may include features (e.g., pillars, holes, gratings, etc.) with at least one dimension (e.g., height, width, thickness, diameter, radius) in the range of 50 nm to a shortest wavelength/2 (e.g., shortest half wavelength) of a target spectra (e.g., up to 400 nm based on a given target spectra, or some other value based on a different target spectra).

In some cases, pixel 200 may be a germanium pixel or indium gallium arsenide pixel. The pixel may include a semiconductor-based image sensor (e.g., photodetector 210). that is part of a 2D array of charge-collection sites, or picture elements (pixels), located below the surface of a semiconductor chip. When an image is focused on the surface, the photodetector generates electron-hole pairs, and the pixels collect the electrons as signal information.

In some examples, inter-layer dielectric layer 220 (e.g., a second inter-layer dielectric) may be formed adjacent to, on, and/or in a semiconductor substrate that includes photodetector 210. Passivation layer 225 may be formed on and/or adjacent to inter-layer dielectric layer 220. Inter-layer dielectric layer 220 may include at least one metal shield (e.g., back-side metal shield). As shown, inter-layer dielectric layer 220 may include a first metal shield below and to the left of photodetector 210 and/or include a second metal shield below and to the right of photodetector 210. As shown, the one or more metal shields of inter-layer dielectric layer 220 may be formed and/or positioned to allow light to pass into the pixel area or admit (e.g., not block) light entering the pixel area of photodetector 210. As shown, inter-layer dielectric layer 220 may include a gap that allows light to pass freely into the pixel area of photodetector 210. Although depicted in FIG. 2 as having a left portion and a right portion, inter-layer dielectric layer 220 may include a border with a center portion removed or not formed. For example, with inter-layer dielectric layer 220 as a square shape, among other possible shapes, the left portion is one side and the right side is one side of four sides bordering or framing the gap.

In some examples, lens 240 may include one or more microlenses. In some cases, lens 240 may include a single microlens (e.g., one microlens per pixel). In some cases, lens 240 may include two or more microlenses per pixel. For example, lens 240 may include a two lens microlens array or a four lens microlens array (e.g., two or four microlenses per pixel). In some cases, pixel 200 is one pixel of multiple pixels of a given image sensor. In some cases, one or more pixels of the image sensor may include one microlens per pixel. Additionally, or alternatively, one or more pixels of the image sensor may include two microlens per pixel (e.g., two lens microlens arrays). Additionally, or alternatively, one or more pixels of the image sensor may include four microlens per pixel (e.g., four lens microlens arrays). Additionally, or alternatively, one or more pixels of the image sensor may include at least one metalens microlens per pixel (e.g., four lens microlens arrays).

Based on the systems and methods described herein, trench insulators in pixel 200 may be optional. For example, trench insulator 215 may be optional in pixel 200. In some cases, pixel 200 may include relatively shallow (e.g., relatively low height) trench insulators. In some cases, based on the linear or relatively linear steering of photons towards photodetector 210, which minimizes crosstalk to adjacent pixels, pixel 200 may be configured without trench insulators. As shown, trench insulator 215 may extend into the pixel area from inter-layer dielectric layer 220 and/or passivation layer 225. Additionally, or alternatively, trench insulator 215 may extend from the gate structure layer.

In some examples, a layer of pixel 200 (e.g., gate structure layer) may include back reflector 205. In some cases, back reflector 205 may include a metal layer (e.g., formed on or as part of a gate structure layer of pixel 200). As shown, a layer of pixel 200 may include anti-reflective layer 235. In some cases, anti-reflective layer 235 may include and/or may be formed with multiple thin dielectric films. In some cases, anti-reflective layer 235 may be configured to minimize light escaping the pixel area of photodetector 210 (e.g., escaped light 255).

In the illustrated example, light incident on pixel 200 (e.g., incident light 245) enters lens 240. Incident light 245 passes through anti-reflective layer 235, nanostructure 230, and passivation layer 225 to enter the pixel area. In the illustrated example, incident light 245 passes between the depicted gap of inter-layer dielectric layer 220. Once in the pixel area, incident light 245 may be referred to as captured light 250. At least a portion of captured light 250 may be absorbed and detected by photodetector 210 (e.g., photons converted to photoelectrons). As shown, at least a portion of captured light 250 may pass through photodetector 210 and/or pass beside photodetector 210. As shown, a portion of captured light 250 that passes through photodetector 210 and/or passes beside photodetector 210 may reflect off of back reflector 205. In some cases, at least a portion of captured light 250 that reflects off back reflector 205 may be absorbed and detected by photodetector 210.

As shown, at least a portion of captured light 250 that reflects off back reflector 205 may pass through passivation layer 225 (e.g., between the depicted gap of inter-layer dielectric layer 220) and reach nanostructure 230. Based on the systems and methods described herein, nanostructure 230 may be configured to permit incident light 245 to pass through nanostructure 230 from anti-reflective layer 235 and/or lens 240. However, nanostructure 230 may be configured to reflect captured light 250 that reflects off back reflector 205 and/or passes through photodetector 210. Accordingly, the design of elements of nanostructure 230 (e.g., a width of an element of nanostructure 230, a height of an element of nanostructure 230, and/or a spacing between a first element and a second element of nanostructure 230) may be configured to minimize light escaping the pixel area of photodetector 210 (e.g., escaped light 255).

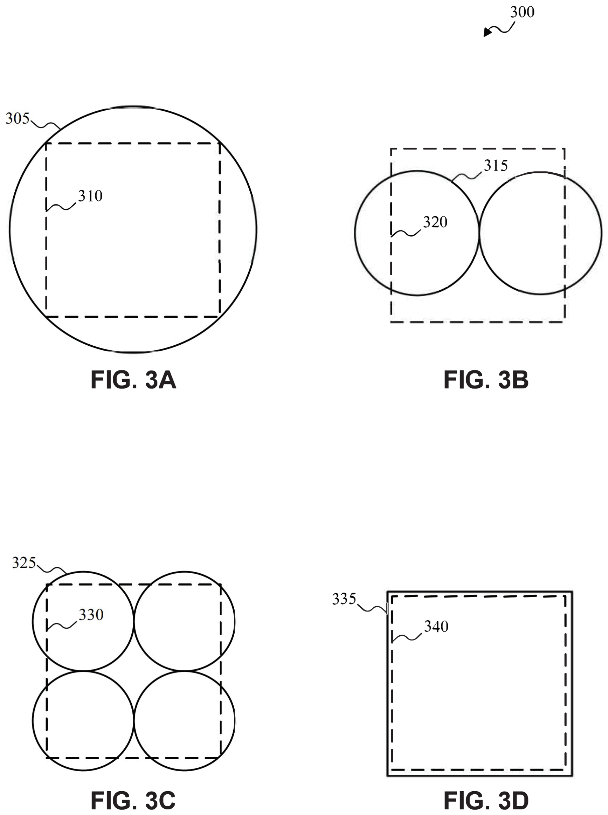

**FIGs. 3A-3D** illustrate example lens configurations 300 in accordance with one or more implementations as described herein. In the illustrated example, non-limiting examples of lens configurations 300 may include lens 305 and pixel 310 of FIG. 3A, lens 315 and pixel 320 of FIG. 3B, lens 325 and pixel 330 of FIG. 3C, and lens 335 and pixel 340 of FIG. 3D. In some cases, lens 105 of FIG. 1 and/or lens 240 of FIG. 2 may be based on at least one lens depicted in lens configurations 300. In some cases, image sensor 110 of FIG. 1 may be based on an image sensor that includes at least one pixel depicted in lens configurations 300. A pixel of lens configurations 300 may be a pixel of an image sensor (e.g., image sensor 110). A pixel of lens configurations 300 may be an example of pixel 200 of FIG. 2.

As shown, lens 305 may be a single microlens, lens 315 may be a two-lens microlens array, lens 325 may be a four-lens microlens array, and lens 335 may be a metalens (e.g., single layer metalens, multi-layer metalens, etc.). In some cases, an imaging device based on the systems and methods described herein may include one or more lenses based on lens configurations 300. For example, an imaging device may include at least one pixel with a single microlens, at least one pixel with a two-lens microlens array, and/or at least one pixel with a four-lens microlens array.

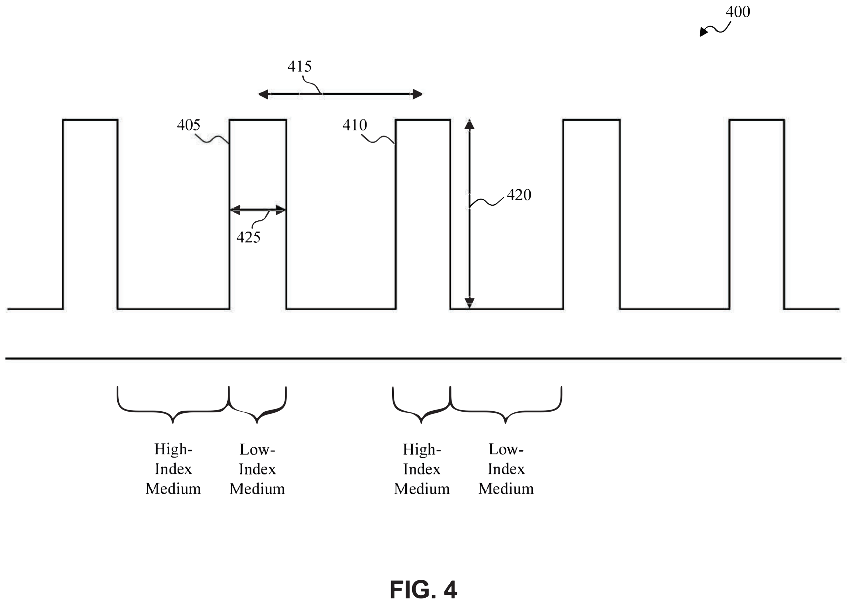

**FIG. 4** illustrates an example nanostructure 400 in accordance with one or more implementations as described herein. In the illustrated example, nanostructure 400 may include at least first element 405 and second element 410. In some examples, nanostructure 400 may include one or more element types, such as pillars, holes, binary gratings, blazed gratings, etc. Elements of nanostructure 400 may be configured with at least one shape such as square, round, oval, spherical, triangular, pyramidical (e.g., 3-sided, 4-sided, etc.), rod, hexagonal, cubic, amorphous, needle-like, crystalline, and/or any given shape. In some examples, first element 405 and second element 410 may be configured with a first shape. In some cases, first element 405 may be configured with a first shape and second element 410 may be configured with a second shape.

As shown, first element 405 and second element 410 may be configured with pitch 415 (e.g., spacing between first element 405 and second element 410). In some cases, two or more elements of nanostructure 400 (e.g., first element 405 and second element 410) may be spaced periodically. Additionally, or alternatively, two or more elements of nanostructure 400 (e.g., first element 405 and second element 410) may be spaced aperiodically). In some cases, a first spacing between first element 405 and second element 410 (e.g., pitch 415) may differ from a second spacing of two other elements of nanostructure 400. In some examples, a spacing between elements (e.g., pitch 415) may be based on a wavelength of a target spectrum (e.g., incident light 245). In some cases, element spacing may be less than (e.g., less than or equal to) one-half the wavelength of the target spectrum (e.g., λ/2). In some cases, element spacing less than (e.g., less than or equal to) 200 nm to 1500 nm.

In the illustrated example, first element 405 may be configured with width 425. In some cases, two or more elements of nanostructure 400 (e.g., first element 405 and second element 410) may be configured with width 425. Additionally, or alternatively, at least one element of nanostructure 400 (e.g., second element 410) may be configured with a second width different from width 425. In some examples, an element width (e.g., width 425) may be based on a wavelength of a target spectrum (e.g., incident light 245). In some cases, the width of an element may be formed at or relatively near one-third the wavelength of the target spectrum (e.g., at or relatively near λ/3). In some cases, the width of an element may be between 100 nm and 1000 nm.

In the illustrated example, second element 410 may be configured with height 420. In some cases, two or more elements of nanostructure 400 (e.g., first element 405 and second element 410) may be configured with height 420. Additionally, or alternatively, at least one element of nanostructure 400 (e.g., first element 405) may be configured with a second height different from height 420. In some examples, an element height (e.g., height 420) may be based on a wavelength of a target spectrum (e.g., incident light 245). In some cases, the height of an element of nanostructure 400 may be proportional to a wavelength of the target spectrum and inversely proportional to an effective refractive index of nanostructure 400. In some cases, the height of an element may be configured to be greater than (e.g., greater than or equal to) the wavelength of the target spectrum over two times the effective refractive index of nanostructure 400 (e.g., λ/2*n_{eff}). In some cases, the height of an element may be between 50 nm and 5000 nm.

In the illustrated example, first element 405 may be configured with a relatively low refractive index (e.g., silicon oxide), while an element adjacent to first element 405 may be configured with a relatively high refractive index (e.g., silicon, Ge, TiO, SiN). Additionally, or alternatively, second element 410 may be configured with a relatively high refractive index, while an element adjacent to second element 410 may be configured with a relatively low refractive index.

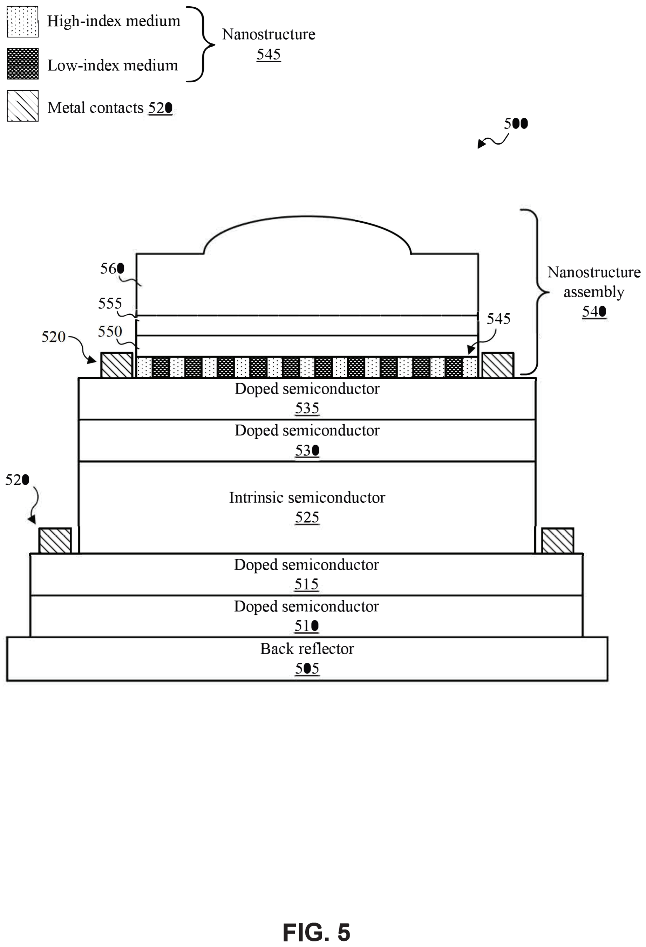

**FIG.** 5 illustrates an example architecture 500 in accordance with one or more implementations as described herein. At least a portion of architecture 500 may be configured as a photodetector. In some cases, architecture 500 may depict at least a portion of a pixel of an image sensor. Architecture 500 may be based on silicon-on-germanium (Si-Ge) photodetection.

In the illustrated example, architecture 500 may include back reflector 505 doped semiconductor 510, doped semiconductor 515, one or more metal contacts (e.g., metal contacts 520) intrinsic semiconductor 525, doped semiconductor 530, doped semiconductor 535, and nanostructure assembly 540. Metal contacts 520 may include one or more types of metal (e.g., aluminum, copper, tin, gold, tungsten, silver, metal alloy, etc.).

Back reflector 505 may include one or more layers of metal, metal contacts (e.g., metal contacts 520), one or more dielectric layers, one or more vias (e.g., through-silicon vias), a Bragg reflector, or any combination thereof. Doped semiconductor 510 may include one or more layers of doped semiconductors. For example, doped semiconductor 510 may include one or more p-doped semiconductors (e.g., p-doped silicon, p-doped germanium). Doped semiconductor 515 may include one or more layers of doped semiconductors. For example, doped semiconductor 515 may include one or more p-doped semiconductors (e.g., p-doped germanium, p-doped silicon).

In some examples, intrinsic semiconductor 525 may include one or more layers of undoped and/or relatively low-doped semiconductors. In some cases, at least a portion of intrinsic semiconductor 525 may be undoped and/or at least a portion of intrinsic semiconductor 525 may include a relatively low-doped semiconductor. For example, intrinsic semiconductor 525 may include at least one layer of intrinsic germanium and/or at least one layer of intrinsic silicon. In some cases, intrinsic semiconductor 525 may be configured as an absorption region of architecture 500 (e.g., of a photodetector of architecture 500). For instances, intrinsic semiconductor 525 may be configured to absorb incident light and convert photons of the light into electrical energy by creating electron-hole pairs.

Doped semiconductor 530 may include one or more layers of doped semiconductors. For example, doped semiconductor 530 may include one or more n-doped semiconductors (e.g., n-doped silicon, n-doped germanium). Doped semiconductor 535 may include one or more layers of doped semiconductors. For example, doped semiconductor 535 may include one or more n-doped semiconductors (e.g., n-doped germanium, n-doped silicon).

As shown, nanostructure assembly 540 may include nanostructure 545, optics layer 550, passivation layer 555, and lens 560. In some cases, nanostructure 545 may be configured to linearize a direction (e.g., minimize scattering) of incident light.

Nanostructure 545 may include one or more mediums. In some cases, nanostructure 545 may include at least a first medium with a first refractive index (e.g., a relatively high-index medium) and at least a second medium with a second refractive index different from (e.g., lower than) the first refractive index (e.g., a relatively low-index medium). In some cases, nanostructure 545 may include relatively low refractive index nanometer structures, relatively low refractive index micrometer structures, relatively high refractive index nanometer structures, and/or relatively high refractive index micrometer structures.

Nanostructure 545 may include subwavelength elements in periodicity of elements and/or in dimensions of elements. In some cases, nanostructure 545 may include elements that do not scatter and/or do not diffract light. Additionally, or alternatively, nanostructure 545 may include elements that scatter or diffract light with minimal scattering angle (e.g., zeroth diffraction order). In some cases, nanostructure 545 may provide up to a Pi radian phase shift on incident light. The phase profile of a given portion of nanostructure 545 may vary spatially within a given pixel and/or vary spatially from a first nanostructure of a first pixel to a second nanostructure of a second pixel.

In some examples, nanostructure 545 may be fabricated from silicon (Si) (e.g., crystalline, amorphous or poly-crystalline silicon (c-Si, a-Si, p-Si)), Germanium (Ge), gallium arsenide (GaAs), indium gallium arsenide (InGaAs), indium phosphide (InP), silicon oxide (SiO), silicon nitride (SixNy) silicon oxynitride (SixOyNz), hafnium oxide (HfO), aluminum oxide (AlO), titanium oxide (TiO), and/or an airgap. In some cases, at least a first portion of a nanostructure may include a relatively high refractive index material (e.g., Si, Ge, TiO, SiN) and at least a second portion of the nanostructure may include a relatively low refractive index material (e.g., SiO, AlO, HfO). In some examples, the high refractive index portion may be positioned adjacent to or beside the low refractive index portion in relation to incident light.

In some cases, one or more components of nanostructure assembly 540 (e.g., nanostructure 545, etc.) may be based on an etching process. In some cases, one or more components of nanostructure assembly 540 may be formed based on chemical etching. At least a portion of nanostructure assembly 540 may be chemically etched within the pixel area (e.g., semiconductor layers of architecture 500). In some cases, nanostructure 545 may include features that extend into a pixel area (e.g., semiconductor layers of architecture 500). In some cases, at least a portion of nanostructure 545 may be incorporated with or embedded in doped semiconductor 535. In some examples, at least a portion of doped semiconductor 535 may be implemented as the first medium of nanostructure 545 or as the second medium of nanostructure 545. For example, the first medium of nanostructure 545 may include at least a portion of doped semiconductor 535 and/or the second medium of nanostructure 545 may include at least a portion of doped semiconductor 535.

Nanostructure 545 may include multiple layers of nanostructures to perform the function of reflecting light back to the photodetector (e.g., to intrinsic semiconductor 525) for a broad range of wavelengths and/or for a broad range of incident light angles. Nanostructure 545 can be formed as square, round, oval, and/or any arbitrary shape. The size of nanostructure 545 may be subwavelength of incident light. A maximum element size of nanostructure 545 (e.g., element width, element diameter, element length, element height) may be a fraction (e.g., half, third, fourth, etc.) of the wavelength of a target spectrum (e.g., a fraction of the lowest wavelength of the target spectrum).

In some examples, optics layer 550 may include one or more optical layers. In some cases, optics layer 550 may include one or more anti-reflection layers configured to reduce light reflection on a surface of nanostructure assembly 440 (e.g., a surface of lens 560, a surface of nanostructure 545, etc.). In some cases, optics layer 550 may include materials that interfere with light incident on nanostructure assembly 540, reducing reflections and allowing more light to pass through to intrinsic semiconductor 525. An antireflective surface of optics layer 550 may include a series of dielectric and/or organic materials such as photoresists, electron-beam resists, germanium, zinc selenide, zinc-sulfide, etc. In some examples, optics layer 550 may include one or more thin-film coatings and/or one or more layers of dielectric thin films for antireflective purposes. Based on the configuration of materials of nanostructure assembly 540, the refractive index of nanostructure assembly 540 may be lower than a refractive index of the pixel area of architecture 500 (e.g., semiconductor layers of architecture 500).

In some examples, passivation layer 555 may include one or more thin films (e.g., one or more dielectric thin film layers and/or one or more thin film coatings). Passivation layer 555 may be fabricated with silicon (Si), silicon oxide (SiOx), silicon nitride (SixNy) silicon oxynitride (SixOyNz), hafnium oxide (HfO), aluminum oxide (AlO), titanium oxide (TiO), etc.

In some examples, lens 560 may include a single microlens or a microlens array (e.g., two lens microlens array, four lens microlens array, etc.). In the illustrated example, lens 560 may be formed on passivation layer 555. In some cases, lens 560 may be made of set of nanostructures or curved organic materials (e.g., curved organic plastics, polymers, acrylics, polycarbonates, etc.).

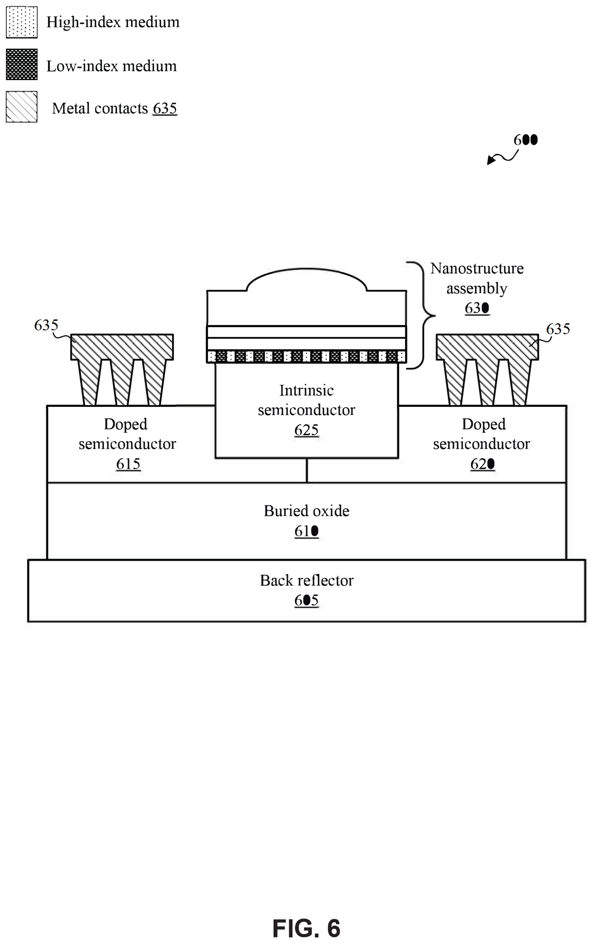

**FIG. 6** illustrates an example architecture 600 in accordance with one or more implementations as described herein. At least a portion of architecture 600 may be configured as a photodetector. In some cases, architecture 600 may depict at least a portion of a pixel of an image sensor. Architecture 600 may be based on silicon-on-germanium (Si-Ge) photodetection.

In the illustrated example, architecture 600 may include back reflector 605, buried oxide 610, doped semiconductor 615, doped semiconductor 620, intrinsic semiconductor 625, nanostructure assembly 630, and metal contacts 635. Metal contacts 635 may be an example of metal contacts 520 of FIG. 5. Metal contacts 635 may include one or more types of metal (e.g., aluminum, copper, tin, gold, tungsten, silver, metal alloy, etc.).

As shown, buried oxide 610 may be formed on back reflector 605. Doped semiconductor 615 and doped semiconductor 620 may be formed on buried oxide 610. Intrinsic semiconductor 625 may be formed within or between doped semiconductor 615 and doped semiconductor 620. As shown, nanostructure assembly 630 may be formed on top of intrinsic semiconductor 625. Nanostructure assembly 630 may be an example of nanostructure assembly 540 of FIG. 5.

Back reflector 605 may include one or more layers of metal, metal contacts (e.g., metal contacts 635), one or more dielectric layers, one or more vias (e.g., through-silicon vias), a Bragg reflector, or any combination thereof.

Buried oxide 610 may include a layer of semiconductor (e.g., silicon dioxide (SiO₂)) that is embedded beneath a top semiconductor (e.g., Si-Ge) layer. Buried oxide 610 may be based on a silicon-on-insulator (SOI) substrate. Buried oxide 610 may be formed between a top semiconductor layer (e.g., Si-Ge absorption region, doped semiconductor 615, doped semiconductor 620, intrinsic semiconductor 625) and a semiconductor substrate (e.g., a handle wafer, buried oxide 610 may include the semiconductor substrate or handle wafer). A thickness of buried oxide 610 may be in the range of 1-3 µm. Buried oxide 610 may prevent light from leaking into the semiconductor substrate, improving light confinement in the active region (intrinsic semiconductor 625), which can be improve the effectiveness of waveguides and photodetectors. In some cases, buried oxide 610 can electrically isolate the active Si-Ge region from the semiconductor substrate, reducing parasitic capacitance and power consumption.

Doped semiconductor 615 may include one or more layers of doped semiconductors. For example, doped semiconductor 615 may include one or more p-doped semiconductors (e.g., p-doped silicon, p-doped germanium). Doped semiconductor 620 may include one or more layers of doped semiconductors. For example, doped semiconductor 620 may include one or more n-doped semiconductors (e.g., n-doped silicon, n-doped germanium).

In some examples, intrinsic semiconductor 625 may include one or more layers of undoped and/or relatively low-doped semiconductors. In some cases, at least a portion of intrinsic semiconductor 625 may be undoped and/or at least a portion of intrinsic semiconductor 625 may be doped at a relatively low level. For example, intrinsic semiconductor 625 may include at least one layer of intrinsic germanium and/or at least one layer of intrinsic silicon. In some cases, intrinsic semiconductor 625 may be configured as an absorption region of architecture 600 (e.g., of a photodetector of architecture 600). For instances, intrinsic semiconductor 625 may be configured to absorb incident light and convert photons of the light into electrical energy by creating electron-hole pairs.

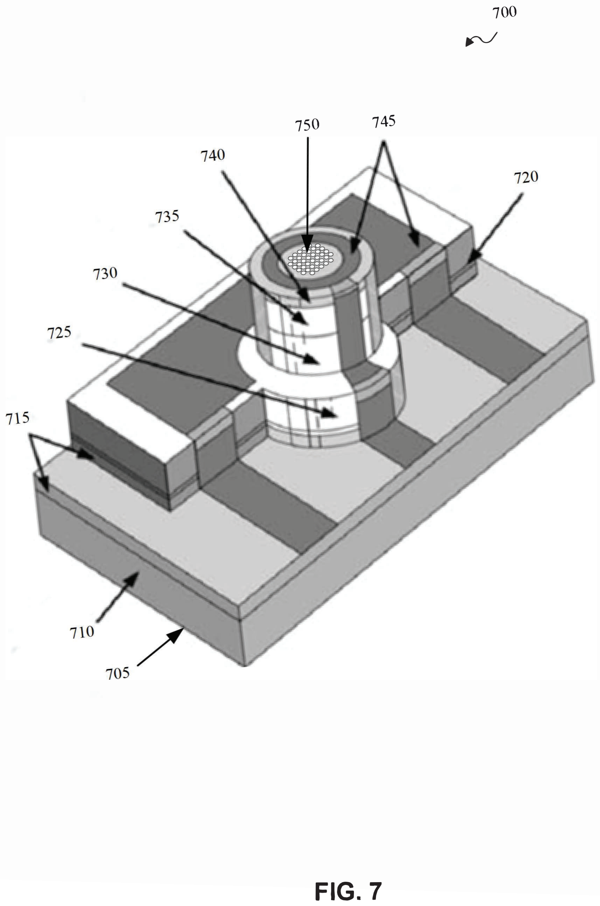

**FIG. 7** illustrates an example architecture 700 in accordance with one or more implementations as described herein. At least a portion of architecture 700 may be configured as a photodetector. In some cases, architecture 700 may depict at least a portion of a pixel of an image sensor. Architecture 700 may be based on silicon-on-germanium (Si-Ge) photodetection.

In the illustrated example, architecture 700 may include back reflector 705, substrate 710, semiconductor 715, buffer 720, semiconductor 725, semiconductor 730, semiconductor 735, semiconductor 740, metal contacts 745, and nanostructure assembly 750. Back reflector 705 may be an example of back reflector 605 of FIG. 6 and/or back reflector 505 of FIG. 5. Metal contacts 745 may be an example of metal contacts 520 of FIG. 5 and/or metal contacts 635 of FIG. 6.

In the illustrated example, substrate 710 may include a doped semiconductor (e.g., p-doped silicon, p-doped germanium, etc.). Semiconductor 715 may include an intrinsic or undoped semiconductor (e.g., intrinsic silicon, intrinsic germanium). At least a portion of semiconductor 715 may include a relatively low-doped semiconductor. Buffer 720 may include a semiconductor buffer (e.g., germanium buffer, silicon buffer). Semiconductor 725 may include a doped semiconductor (e.g., p-doped germanium, p-doped silicon). Semiconductor 730 may include an intrinsic or undoped semiconductor (e.g., intrinsic germanium, intrinsic silicon). Semiconductor 735 may include a doped semiconductor (e.g., n-doped germanium, n-doped silicon). Semiconductor 740 may include a doped semiconductor (e.g., n-doped silicon, n-doped germanium). In some cases, semiconductor 740 may be configured as a semiconductor capping layer. Examples of a capping layer material of semiconductor 740 may include at least one of silicon nitride, silicon carbon nitride, silicon oxide carbide, titanium, titanium nitride, copper alloy, etc. Metal contacts 745 may include one or more types of metal (e.g., aluminum, copper, tin, gold, tungsten, silver, metal alloy, etc.). Nanostructure assembly 750 may be an example of nanostructure assembly 630 of FIG. 6 and/or nanostructure assembly 540 of FIG. 5.

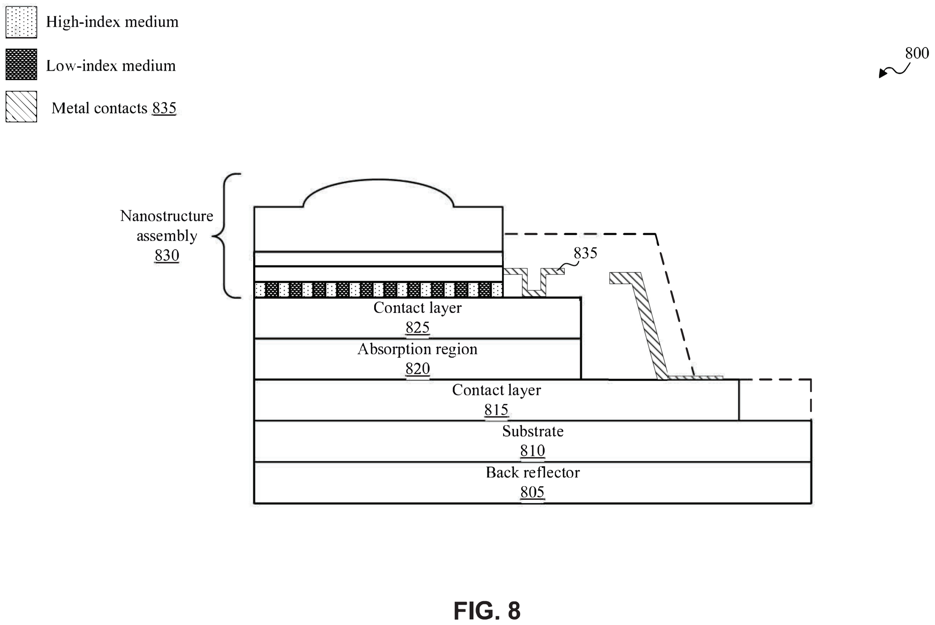

**FIG. 8** illustrates an example architecture 800 in accordance with one or more implementations as described herein. At least a portion of architecture 800 may be configured as a photodetector. In some cases, architecture 800 may depict at least a portion of a pixel of an image sensor. Architecture 800 may be based on silicon-on-germanium (Si-Ge) photodetection.

In the illustrated example, architecture 800 may include back reflector 805, substrate 810, contact layer 815, absorption region 820, contact layer 825, nanostructure assembly 830, and metal contacts 835. Back reflector 805 may be an example of back reflector 705 of FIG. 7, back reflector 605 of FIG. 6, and/or back reflector 505 of FIG. 5. Metal contacts 835 may be an example of metal contacts 745 of FIG. 7, metal contacts 635 of FIG. 6, and/or metal contacts 520 of FIG. 5. Nanostructure assembly 830 may be an example of nanostructure assembly 750 of FIG. 7, nanostructure assembly 630 of FIG. 6, and/or nanostructure assembly 540 of FIG. 5. At least some portions of architecture 800 may be encapsulated with a capping layer material as indicated by the dotted lines of architecture 800. Examples of the capping layer material may include at least one of silicon nitride, silicon carbon nitride, silicon oxide carbide, titanium, titanium nitride, copper alloy, etc.

In some cases, substrate 810 may include a semiconductor substrate (e.g., silicon substrate). In some cases, substrate 810 may be formed as a high-resistance semiconductor substrate (e.g., high-resistance silicon substrate). The relatively high resistance of substrate 810 may be based on minimizing the concentration of free charge carriers (e.g., electrons or holes) within the silicon crystal. The relatively high resistance of substrate 810 may range from 7,000 Ohm-cm to over 10,000 Ohm-cm.

Contact layer 815 may include one or more layers of doped semiconductors. For example, contact layer 815 may include one or more n-doped semiconductors (e.g., n-doped germanium, n-doped silicon, n-doped indium phosphide).

Absorption region 820 may include one or more layers of undoped and/or relatively low-doped semiconductors. In some cases, at least a portion of absorption region 820 may be undoped and/or at least a portion of absorption region 820 may include a relatively low-doped semiconductor. For example, absorption region 820 may include at least one layer of intrinsic germanium, at least one layer of intrinsic silicon and/or at least one layer of intrinsic indium gallium arsenide. In some cases, absorption region 820 may be configured as an absorption region of a photodetector of architecture 800. For instances, absorption region 820 may be configured to absorb incident light and convert photons of the light into electrical energy by creating electron-hole pairs.

Contact layer 825 may include one or more layers of doped semiconductors. For example, contact layer 825 may include one or more p-doped semiconductors (e.g., p-doped germanium, p-doped silicon, p-doped indium phosphide).

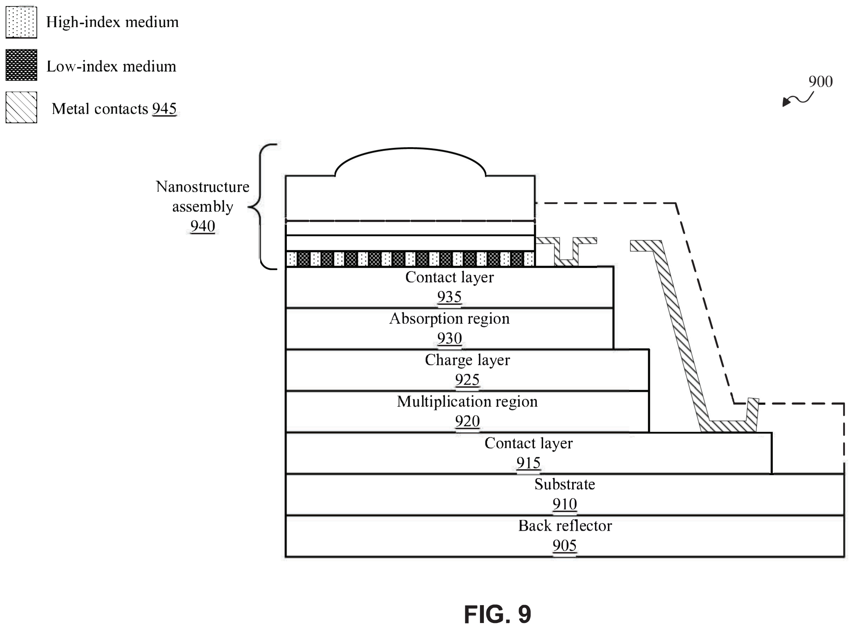

**FIG. 9** illustrates an example architecture 900 in accordance with one or more implementations as described herein. At least a portion of architecture 900 may be configured as a photodetector. In some cases, architecture 900 may depict at least a portion of a pixel of an image sensor. Architecture 900 may be based on silicon-on-germanium (Si-Ge) photodetection.

In the illustrated example, architecture 900 may include back reflector 905, substrate 910, contact layer 915, multiplication region 920, charge layer 925, absorption region 930, contact layer 935, nanostructure assembly 940, and metal contacts 945. Back reflector 905 may be an example of back reflector 805 of FIG. 8, back reflector 705 of FIG. 7, back reflector 605 of FIG. 6, and/or back reflector 505 of FIG. 5. Metal contacts 945 may be an example of metal contacts 835 of FIG. 8, metal contacts 745 of FIG. 7, metal contacts 635 of FIG. 6, and/or metal contacts 520 of FIG. 5. Nanostructure assembly 940 may be an example of nanostructure assembly 830 of FIG. 8, nanostructure assembly 750 of FIG. 7, nanostructure assembly 630 of FIG. 6, and/or nanostructure assembly 540 of FIG. 5. At least some portions of architecture 900 may be encapsulated with a capping layer material as indicated by the dotted lines of architecture 900. Examples of the capping layer material may include at least one of silicon nitride, silicon carbon nitride, silicon oxide carbide, titanium, titanium nitride, copper alloy, etc.

In some cases, substrate 910 may include a semiconductor substrate (e.g., silicon substrate). In some cases, substrate 910 may be formed as a high-resistance semiconductor substrate (e.g., high-resistance silicon substrate). The relatively high resistance of substrate 910 may be based on minimizing the concentration of free charge carriers (e.g., electrons or holes) within the silicon crystal. The relatively high resistance of substrate 910 may range from 7,000 Ohm-cm to over 10,000 Ohm-cm.

Contact layer 915 may include one or more layers of doped semiconductors. For example, contact layer 915 may include one or more n-doped semiconductors (e.g., n-doped germanium, n-doped silicon, n-doped indium phosphide).

Multiplication region 920 may include one or more layers of intrinsic or undoped (e.g., relatively low-doped) semiconductors. For example, multiplication region 920 may include one or more layers of intrinsic germanium, intrinsic silicon, and/or intrinsic indium phosphide. A thickness of multiplication region 920 may range from 0.1 µm to 1 µm (e.g., 0.5 µm). In some cases, multiplication region 920 may be configured to enhance the sensitivity of architecture 900 by amplifying photo-generated charge carriers.

Charge layer 925 may be configured to facilitate the efficient movement of charge carriers (e.g., electrons or holes) towards respective electrodes. The enhancement in charge transport can speed up the detection process and can improve a photodetector's overall performance, particularly in terms of efficiency and speed. In some cases, charge layer 925 can include a hole transport layer and/or an electron transport layer. Charge layer 925 may include may include one or more layers of doped semiconductors. For example, charge layer 925 may include one or more p-doped semiconductors (e.g., p-doped germanium, p-doped silicon, p-doped indium phosphide). A thickness of charge layer 925 may range from 10 nm to 1 µm (e.g., 0.1 µm).

Absorption region 930 may include one or more layers of undoped and/or relatively low-doped semiconductors. In some cases, at least a portion of absorption region 930 may be undoped and/or at least a portion of absorption region 930 may include a relatively low-doped semiconductor. For example, absorption region 930 may include at least one layer of intrinsic germanium, at least one layer of intrinsic silicon and/or at least one layer of intrinsic indium gallium arsenide. In some cases, absorption region 930 may be configured as an absorption region of a photodetector of architecture 900. For instances, absorption region 930 may be configured to absorb incident light and convert photons of the light into electrical energy by creating electron-hole pairs.

Contact layer 935 may include one or more layers of doped semiconductors. For example, contact layer 935 may include one or more p-doped semiconductors (e.g., p-doped germanium, p-doped silicon, p-doped indium phosphide). A thickness of contact layer 935 may range from 10 nm to 1 µm (e.g., 0.1 µm).

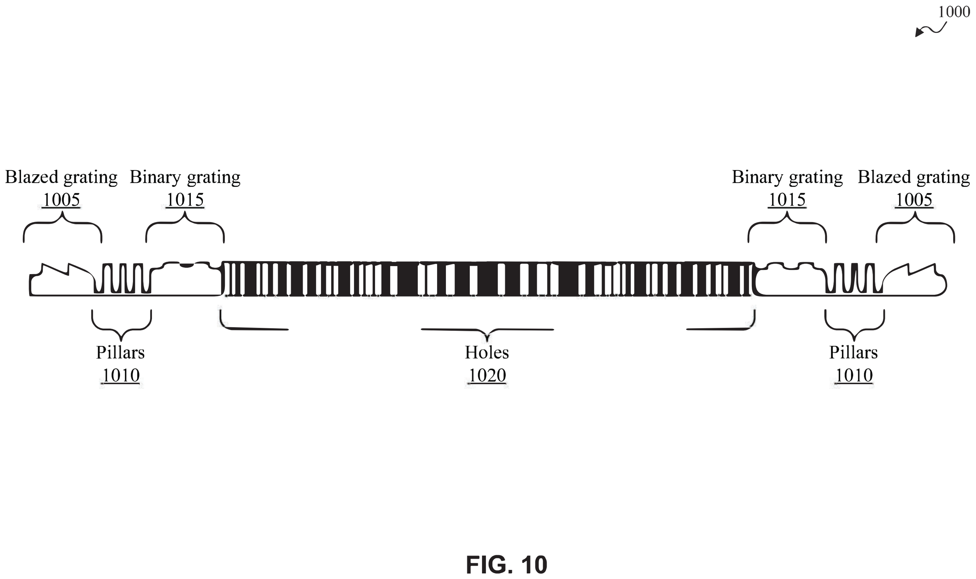

**FIG. 10** illustrates an example nanostructure 1000 in accordance with one or more implementations as described herein. In some examples, nanostructure 1000 depicts a side view of a nanostructure that may be part of an imaging system (e.g., imaging system 100 of FIG. 1). Nanostructure 1000 may be an example of nanostructure 230 of FIG. 2 and/or nanostructure 400 of FIG. 4.

Nanostructure 1000 may include at least one nanostructure (e.g., one or more layers of nanostructures). In some cases, a top surface of nanostructure 1000 may include one or more nanostructure elements. Additionally, or alternatively, a bottom surface of nanostructure 1000 may include one or more nanostructure elements. In some examples, at least one element of nanostructure 1000 may be formed based on dry etching and/or wet etching.

The systems and methods described herein (e.g., nanostructures, anti-reflective layers, lenses, microlenses, metalenses, meta materials) may implement one or more types of optical gratings. An optical grating, also known as a diffraction grating, may be an optical element that splits electromagnetic radiation (e.g., heat, light) into multiple beams that move in different directions. Optical gratings may be made up of parallel lines or grooves that are engraved on a surface. A type of grating can have many evenly spaced parallel slits. When polychromatic light hits the grating, each wavelength of light is reflected at a slightly different angle. For example, red light is bent further than blue light because red light has a longer wavelength. Thus, diffraction grating breaks up the colors of white light. Diffraction gratings are used in many scientific and technological applications. Diffraction gratings are typically better than prisms because they are more efficient, give a linear dispersion of wavelengths, and are free of absorption effects. Diffraction gratings work for both transmission and reflection of electromagnetic radiation. Examples of natural diffraction gratings include butterfly wings, the Australian opal, and the feathers of some birds like hummingbirds. Diffraction gratings may include binary gratings and/or blazed gratings.

Binary gratings may include a periodic structure that causes optical amplitude and/or phase changes. A binary grating may include a periodic structure that has a binary change in phase or amplitude within a single period. A binary grating is a periodic structure with binary change in amplitude or phase within one period. Binary line gratings are often used in spectrometers. Binary gratings may have grating periods greater than one wavelength, but use subwavelength structures within one period. This allows binary gratings to achieve high efficiencies of 70-80%. Binary phase gratings are similar to binary amplitude gratings, but the opaque regions are replaced by etched grooves. Diffraction gratings separate the wavelength components of electromagnetic radiation (e.g., heat, light) by directing each wavelength into a unique output angle. Diffraction gratings, such as binary gratings, may be used in monochromators and spectrometers, but also have other applications, such as optical encoders and wavefront measurement. Binary line gratings can diffract electromagnetic radiation in several directions due to the symmetry of the structure, whereas blazed and slanted gratings may diffract in a single direction.

Blazed gratings are a type of diffraction grating optimized for maximum efficiency in a given diffraction order. Blazed gratings are also known as echelette gratings or saw-tooth gratings. Blazed gratings have a triangular, sawtooth-shaped cross section, forming a step structure. The steps are tilted at the blaze angle with respect to the grating surface. The blaze angle is optimized to maximize efficiency for the wavelength of the used light. Blazed gratings operate at a specific wavelength, known as the blaze wavelength. This means that the majority of the optical power will be in the designed diffraction order while minimizing power lost to other orders. Blazed gratings are relatively efficient and are a good choice for applications with high signal strength constraints.

In the illustrated example, nanostructure 1000 may include nanostructure elements such as blazed gratings 1005, pillars 1010, binary gratings 1015, and/or holes 1020. In some examples, nanostructure 1000 may include one or more patterns of diffraction grating (e.g., a pattern of blazed grating 1005 and/or binary grating 1015). In some cases, pillars 1010 may include one or more patterns of pillars (e.g., repeating patterns, periodic patterns, aperiodic patterns). In some implementations, holes 1020 may include one or more patterns of holes (e.g., repeating patterns, periodic patterns, aperiodic patterns).

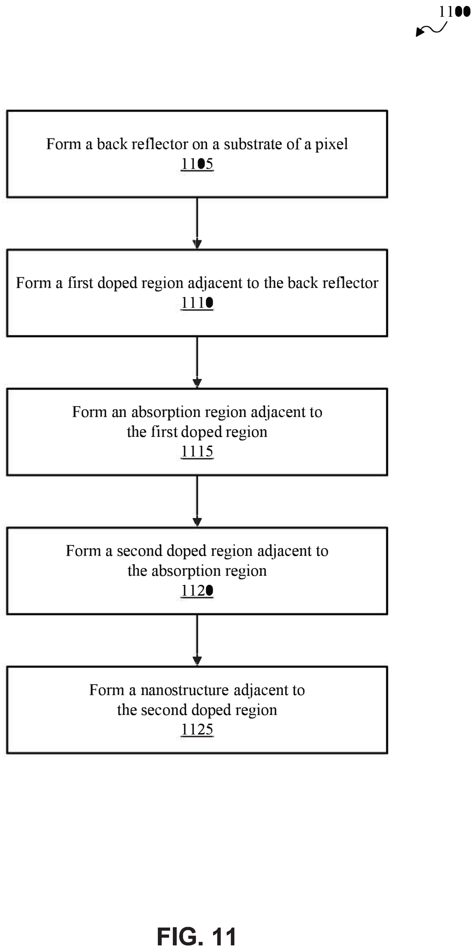

**FIG. 11** depicts a flow diagram illustrating an example method 1100 associated with the disclosed systems, in accordance with example implementations described herein. The depicted method 1100 is just one implementation and one or more operations of method 1100 may be rearranged, reordered, omitted, and/or otherwise modified such that other implementations are possible and contemplated. FIG. 11 illustrates an example flow diagram of short-wave infrared pixels based on non-scattering nanostructures.

At 1105, method 1100 may include forming a back reflector on a substrate of a pixel. For example, method 1100 may include forming a back reflector on a substrate of a pixel, the back reflector being configured to reflect electromagnetic radiation.

At 1110, method 1100 may include forming a first doped region adjacent to the back reflector. For example, method 1100 may include forming a first doped region of a first semiconductor adjacent to the back reflector.

At 1115, method 1100 may include forming an absorption region adjacent to the first doped region. For example, method 1100 may include forming an absorption region of a second semiconductor adjacent to at least a portion of the first doped region, the absorption region being configured as a photodetector.

At 1120, method 1100 may include forming a second doped region adjacent to the absorption region. For example, method 1100 may include forming a second doped region of the first semiconductor adjacent to the absorption region, the second doped region being configured to pass the electromagnetic radiation to the absorption region.

At 1125, method 1100 may include forming a nanostructure adjacent to the second doped region. For example, method 1100 may include forming a nanostructure adjacent to the second doped region, the nanostructure configured to allow light incident on the pixel to pass through the nanostructure and to steer a portion of the light reflected off the back reflector towards the absorption region.

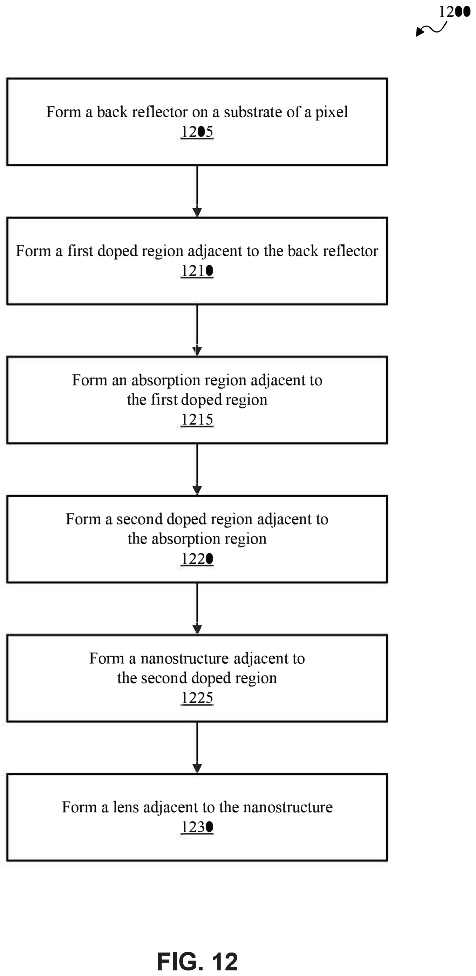

**FIG. 12** depicts a flow diagram illustrating an example method 1200 associated with the disclosed systems, in accordance with example implementations described herein. The method 1200 is just one implementation and one or more operations of the method 1200 may be rearranged, reordered, omitted, and/or otherwise modified such that other implementations are possible and contemplated. FIG. 12 illustrates an example flow diagram of short-wave infrared pixels based on non-scattering nanostructures.

At 1205, method 1200 may include forming a back reflector on a substrate of a pixel. For example, method 1200 may include forming a back reflector on a substrate of a pixel, the back reflector being configured to reflect electromagnetic radiation.

At 1210, method 1200 may include forming a first doped region adjacent to the back reflector. For example, method 1200 may include forming a first doped region of a first semiconductor adjacent to the back reflector.

At 1215, method 1200 may include forming an absorption region adjacent to the first doped region. For example, method 1200 may include forming an absorption region of a second semiconductor adjacent to at least a portion of the first doped region, the absorption region being configured as a photodetector.

At 1220, method 1200 may include forming a second doped region adjacent to the absorption region. For example, method 1200 may include forming a second doped region of the first semiconductor adjacent to the absorption region, the second doped region being configured to pass the electromagnetic radiation to the absorption region.

At 1225, method 1200 may include forming a nanostructure adjacent to the second doped region. For example, method 1200 may include forming a nanostructure adjacent to the second doped region, the nanostructure configured to allow light incident on the pixel to pass through the nanostructure and to steer a portion of the light reflected off the back reflector towards the absorption region.

At 1230, method 1200 may include forming a lens adjacent to the nanostructure. For example, method 1200 may include forming a microlens adjacent to the nanostructure. The microlens may include at least one of a flat coat layer or a curved lensing layer. The nanostructure may include a passivation layer formed adjacent to the microlens. The passivation layer may include at least one thin film dielectric.

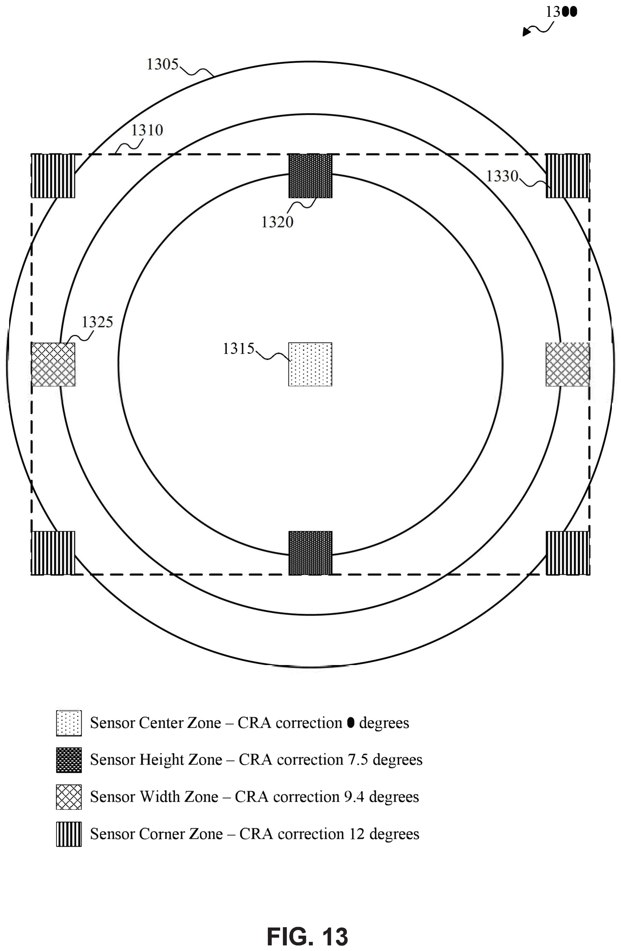

**FIG. 13** illustrates an example system 1300 in accordance with one or more implementations as described herein. In the illustrated example, system 1300 may include lens 1305 and image sensor 1310. Although system 1300 is depicted with one lens for one image sensor, the same configurations may apply to systems with multiples lenses per image sensor (e.g., at least one lens per pixel of the image sensor). System 1300 may be a system of an image device (e.g., camera, thermal imaging device, ADAS, in-cabin sensors, etc.). In some examples, image sensor 1310 may include one or more pixels. In some cases, at least one pixel of image sensor 1310 may include (e.g., may be paired with) at least one nanostructure (e.g., nanostructure 1315, nanostructure 1320, nanostructure 1325, nanostructure 1330, etc.). In some cases, a nanostructure of system 1300 may correspond to a pixel of image sensor 1310. For example, a first pixel of image sensor 1310 may include nanostructure 1315, a second pixel of image sensor 1310 may include nanostructure 1320, a third pixel of image sensor 1310 may include nanostructure 1325, a fourth pixel of image sensor 1310 may include nanostructure 1330, and so on. Accordingly, nanostructure 1315 may receive a first portion of light incident on system 1300 and steer the first portion of light towards a photodetector of the first pixel of image sensor 1310, nanostructure 1320 may receive a second portion of light incident on system 1300 and steer the second portion of light towards a photodetector of the second pixel of image sensor 1310, and so on.

Based on the systems and methods described herein, nanostructures for pixels at or relatively near the center of the image sensor may have a chief ray angle (CRA) correction different from the CRA correction of nanostructures at a first radius out from the center of the image sensor, both of which may be different from the CRA correction of nanostructures at a second radius out from the center of the image sensor that is further than the first radius, and so on.

For illustrative purposes, lens 1305 is depicted with multiple concentric rings. In some cases, the concentric rings are depicted to indicate the position of pixels/nanostructures relative to image sensor 1310. As shown, the pixels of image sensor 1310 are located at different positions relative to image sensor 1310 and/or lens 1305. For example, nanostructure 1315 is at or relatively near a center position of image sensor 1310 and/or lens 1305, nanostructure 1320 is at the first concentric ring or a first radius of image sensor 1310 and/or lens 1305, nanostructure 1325 is at the second concentric ring or a second radius of image sensor 1310 and/or lens 1305 further from the center than the first radius, nanostructure 1330 is at the third concentric ring or a third radius of image sensor 1310 and/or lens 1305 further from the center than the second radius. Other pixels/nanostructures of image sensor 1310 may be located at different positions and/or relatively at similar positions (e.g., similar radius from the center of image sensor 1310 and/or lens 1305), at positions nearer the center of image sensor 1310 and/or lens 1305, and/or positions further away from the center of image sensor 1310 and/or lens 1305 relative to at least one pixel/nanostructure depicted in system 1300. It is noted that the size of the illustrated pixels/nanostructures may not be to scale with the size of lens 1305 and/or sensor 1310.

In some examples, pixels of an image sensor may be configured with customized or semi-customized nanostructure configurations. In some cases, a first nanostructure may be based on a first CRA correction, a second nanostructure may be based on a second CRA correction, and so on, based on the respective locations of the nanostructures relative to the pixel locations on the image sensor.

In the illustrated example, nanostructure 1315 may be configured with a first nanostructure configuration (e.g., sensor center zone configuration, CRA correction of 0 degrees), nanostructure 1320 may be configured with a second nanostructure configuration (e.g., sensor center zone configuration, CRA correction of 7.5 degrees), nanostructure 1325 may be configured with a third nanostructure configuration (e.g., sensor center zone configuration, CRA correction of 9.4 degrees), nanostructure 1330 may be configured with a fourth nanostructure configuration (e.g., sensor center zone configuration, CRA correction of 12 degrees). In some examples, less or more nanostructure configurations may be implemented with different CRA corrections than those depicted. Accordingly, the nanostructures of system 1300 may be configured to steer light directly towards a photodetector instead of scattering the incident light throughout the pixel area, thus reducing crosstalk and dark noises, etc.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" is used herein to mean "serving as an example, instance, or illustration." Any embodiment described herein as "exemplary" is not necessarily to be construed as preferred or advantageous over other embodiments. The terms "computing device," "user device," "communication station," "station," "handheld device," "mobile device," "wireless device" and "user equipment" (UE) as used herein refers to a wireless communication device such as a cellular telephone, smartphone, tablet, netbook, wireless terminal, laptop computer, a femtocell, High Data Rate (HDR) subscriber station, access point, printer, point of sale device, access terminal, or other personal communication system (PCS) device. The device may be either mobile or stationary.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example, an FPGA (field programmable gate array) or an ASIC (application-specific integrated circuit). The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, for example a CRT (cathode ray tube) or LCD (liquid crystal display) monitor, for displaying information/data to the user and a keyboard and a pointing device, for example a mouse or a trackball, by which the user can provide input to the computer. Other kinds of devices can be used to provide for interaction with a user as well; for example, feedback provided to the user can be any form of sensory feedback, for example visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, for example, as an information/data server, or that includes a middleware component, for example, an application server, or that includes a front-end component, for example, a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example, an HTML page) to a client device (for example, for purposes of displaying information/data to and receiving user input from a user interacting with the client device). Information/data generated at the client device (for example, a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

## Claims

1. A pixel of an image sensor comprising:
a back reflector (205, 505, 605, 705, 805, 905) formed on a substrate, the back reflector being configured to reflect electromagnetic radiation;
a first doped region (510, 515, 615, 725, 815, 915) of a first semiconductor formed adjacent to the back reflector (205, 505, 605, 705, 805, 905);
an absorption region (525, 625, 820, 930) of a second semiconductor configured as a photodetector of the pixel, the absorption region being formed adjacent to at least a portion of the first doped region (510, 515, 615, 725, 815, 915);
a second doped region (530, 535, 620, 735, 825, 935) of the first semiconductor formed adjacent to the absorption region (525, 625, 820, 930), the second doped region (530, 535, 620, 735, 825, 935) being configured to pass the electromagnetic radiation to the absorption region; and
a nanostructure (230, 400, 545, 1000) formed adjacent to the second doped region (530, 535, 620, 735, 825, 935), the nanostructure (230, 400, 545, 1000) being configured to:
steer light that passes through the nanostructure (230, 400, 545, 1000) towards the absorption region (525, 625, 820, 930); and
steer, towards the absorption region (525, 625, 820, 930), a portion of the light that reflects off the back reflector (205, 505, 605, 705, 805, 905).

2. The pixel of claim 1, wherein:
the nanostructure (230, 400, 545, 1000) comprises segments of a first material interleaved with segments of a second material,
the first material has a first refractive index, and
the second material has a second refractive index different from the first refractive index.

3. The pixel of claim 2, wherein the second material comprises at least a portion of the second doped region (530, 535, 735, 825, 935).

4. The pixel of any one of claims 1 to 3, wherein:
the pixel comprises a metal contact, the metal contact connecting the pixel to a transistor, and
the back reflector (205, 505, 605, 705, 805, 905) comprises at least one of one or more metal layers, one or more dielectric layers, one or more vias of the pixel, or at least a portion of the metal contact.

5. The pixel of any one of claims 1 to 4, wherein:
at least a portion of the absorption region (525, 625, 820, 930) comprises an undoped semiconductor,
the first doped region (510, 515, 615, 725, 815, 915) comprises a first doping, and
the second doped region (530, 535, 620, 735, 825, 935) comprises a second doping, the second doping having an opposite polarity of the first doping.

6. The pixel of any one of claims 1 to 5, wherein:
the first semiconductor comprises at least one of silicon, germanium, or indium phosphide, and
the second semiconductor comprises at least one of germanium or indium gallium arsenide.

7. The pixel of any one of claims 1 to 6, wherein at least one of the first semiconductor or the second semiconductor comprise at least one of gallium arsenide, cadmium telluride, mercury cadmium telluride, lead sulfide, indium arsenide, vanadium oxide, phosphorene, or graphene.

8. The pixel of any one of claims 1 to 7, wherein a height (420) of an element of the nanostructure (400):
is greater than or equal to a lowest wavelength of a target electromagnetic radiation spectra, and
is inversely proportional to an effective refractive index of a material of the nanostructure (400).

9. The pixel of claim 8, wherein a spacing between a first element and a second element of the nanostructure is less than or equal to half of the lowest wavelength of the target electromagnetic radiation spectra.

10. The pixel of any one of claims 1 to 9, wherein the nanostructure comprises at least one of an element spacing, an element width, an element height, or an element type, the element type including at least one of a pillar, a hole, or a grating.

11. The pixel of any one of claims 1 to 10, further comprising: a microlens formed adjacent to the nanostructure, the microlens comprising one or more lenses (240, 305, 315, 325, 335, 560, 1305) that include at least one of a flat coat layer or a curved lensing layer, wherein the nanostructure comprises a passivation layer (225, 555) formed adjacent to the microlens, the passivation layer (225, 555) comprising at least one thin film dielectric.

12. The pixel of any one of claims 1 to 11, wherein:
the nanostructure is configured for a first chief ray angle, CRA, based on a first lens of the pixel, and
a second pixel is associated with a second nanostructure configured for a second CRA based on a second lens of the second pixel, the second CRA being different from the first CRA.

13. A method comprising:
forming (1105, 1205) a back reflector (205, 505, 605, 705, 805, 905) on a substrate of a pixel, the back reflector being configured to reflect electromagnetic radiation;
forming (1110, 1210) a first doped region (510, 515, 615, 725, 815, 915) of a first semiconductor adjacent to the back reflector (205, 505, 605, 705, 805, 905);
forming (1215) an absorption region (525, 625, 820, 930) of a second semiconductor adjacent to at least a portion of the first doped region (510, 515, 615, 725, 815, 915), the absorption region (525, 625, 820, 930) being configured as a photodetector;
forming (1120, 1220) a second doped region (530, 535, 620, 735, 825, 935) of the first semiconductor adjacent to the absorption region (525, 625, 820, 930), the second doped region (530, 535, 620, 735, 825, 935) being configured to pass the electromagnetic radiation to the absorption region; and
forming (1125, 1225) a nanostructure (230, 400, 545, 1000) adjacent to the second doped region (530, 535, 620, 735, 825, 935), the nanostructure (230, 400, 545, 1000) configured to allow light incident on the pixel to pass through the nanostructure (230, 400, 545, 1000) and to steer a portion of the light reflected off the back reflector (205, 505, 605, 705, 805, 905) towards the absorption region (525, 625, 820, 930).

14. The method of claim 13, wherein:
the nanostructure (230, 400, 545, 1000) comprises segments of a first material interleaved with segments of a second material,
the first material has a first refractive index, and
the second material has a second refractive index different from the first refractive index.

15. The method of claim 13 or 14, wherein the second material comprises at least a portion of the second doped region (530, 535, 620, 735, 825, 935).
